# EUROPÄISCHE PATENTSCHRIFT

(11) **EP 3 884 239 B1**
(45) Veröffentlichungstag und Bekanntmachung des Hinweises auf die Patenterteilung: **24.04.2024**
(21) Anmeldenummer: 19813430.6
(22) Anmeldetag: 21.11.2019
(51) Int. Cl.: G01D 5/14, G01D 5/244, B62D 15/02

(54) **WINKELSENSOR MIT MEHRPOLIGEM MAGNET FÜR EINE KRAFTFAHRZEUGLENKUNG**
ANGLE SENSOR WITH MULTIPOLE MAGNET FOR MOTOR VEHICLE STEERING
CAPTEUR D'ANGLE AVEC AIMANT MULTIPOLE POUR LA DIRECTION D'UN VÉHICULE AUTOMOBILE

(30) Priorität: 22.11.2018 DE 102018129487
(43) Veröffentlichungstag der Anmeldung: 29.09.2021
(73) Patentinhaber: thyssenkrupp Presta AG, 9492 Eschen (LI); thyssenkrupp AG, 45143 Essen (DE)
(72) Erfinder: PÁDÁR, Péter, 1031 Budapest (HU); VÉR, Ábel, 2083 Solymár (HU)
(74) Vertreter: thyssenkrupp Intellectual Property GmbH
(86) Internationale Anmeldenummer: PCT/EP2019/082097
(87) Internationale Veröffentlichungsnummer: WO 2020/104593

(56) Entgegenhaltungen:
- EP-A1- 1 777 501
- EP-A1- 1 818 659
- DE-A1-102015 114 608
- US-A- 5 568 048
- US-A- 5 680 042
- US-A1- 2003 145 663
- US-A1- 2012 161 755

## Beschreibung

Die vorliegende Erfindung betrifft einen Winkelsensor mit den Merkmalen des Anspruchs 1, eine elektromechanische Hilfskraftlenkung und eine Steer-by-Wire Lenkung für ein Kraftfahrzeug aufweisend die entsprechenden Winkelsensoren und ein Verfahren zur Bestimmung eines Drehwinkels der Drehlage einer drehbar gelagerten Lenkwelle eines Kraftfahrzeuges mit den Merkmalen des Anspruchs 9.

Winkelsensoren werden in einem Kraftfahrzeug unter anderem dazu eingesetzt den Einschlagwinkel des Lenkrades zu messen. Derzeit verwendete Winkelsensoren sind magnetische Sensoren, deren Messung sehr leicht durch externe Magnetfelder gestört werden kann. Kraftfahrzeuge werden in Zukunft und zum Teil schon jetzt, vollständig oder teilweise elektrisch betrieben, was zu hohen externen Feldbeeinflussungsmessungen durch hochstromführende Kabel führen kann, die sich häufig in der Nähe des Lenksystems befinden. Diese Störungen der magnetischen Sensoren können somit das Lenkgefühl und die Robustheit der Lenkung negativ beeinflussen.

EP 2 552 000 A2 offenbart einen Elektromotor mit Rotorpositionssensor, der ein Streumagnetfeld des permanentmagnetisch ausgebildeten Rotors erfasst und das Rotorpositionssignal in Abhängigkeit des Streumagnetfeldes erzeugt. Der Elektromotor braucht so vorteilhafterweise keinen gesonderten Rotorpositionsmagneten, um die Rotorposition des Rotors zu erfassen. Es ist zudem aus der Offenlegungsschrift DE 10 2008 043 265 A1 bekannt, die durch ein magnetisches Störfeld entstehenden Störungen zu kompensieren, indem das magnetische Störfeld bestimmt wird und vektoriell von einem Magnetfeldvektor subtrahiert wird.

Zudem ist aus der EP 1 777 501 A1 ein Positionssensor für eine berührungslose Positionsbestimmung bekannt, der die Verwendung eines Multipol-Magnetrings mit wenigstens zwei zu einander versetzten magnetempfindlichen Sensorelementen zur Störfeldkompensation vorsieht. Der Positionssensor ist dabei auch zur Winkelbestimmung geeignet. Ein ähnlich ausgebildeter Sensor zur Bestimmung eines Winkels ist aus der US 5 568 048 A bekannt. Ein weiterer Winkelsensor mit mehreren einem Magneten zugeordneten Sensoren ist aus der US 2012/161755 A1 bekannt. Weitere ähnliche Sensorsysteme, die zwei Multipol-Magnetringe vorsehen, wobei jedem der Magnetringe ein magnetempfindlicher Sensor zugeordnet ist, sind aus der DE 10 2015 114 608 A1 und aus der EP 1 818 659 A1 bekannt. Auch in der US 2003/145663 A1 wird ein Sensorsystem mit Multipol-Magnetringen und mehreren Sensorelementen beschrieben. Für den Einsatz in Encodern und Tachometern ist der Einsatz von Magnetringen mit einer Vielzahl von Polen und einer diesen zugeordneten Sensoranordnung aus der US 5 680 042 A bekannt.

Es ist Aufgabe der vorliegenden Erfindung einen Winkelsensor anzugeben, der eine erhöhte Genauigkeit und einen verringerten Einfluss eines vorhandenen magnetischen Störfeldes auf die Ermittlung des Drehwinkelwertes aufweist.

Diese Aufgabe wird von einem Winkelsensor mit den Merkmalen des Anspruchs 1 und einem Verfahren zur Bestimmung eines Drehwinkels der Drehlage einer Rotorwelle eines Elektromotors einer Kraftfahrzeuglenkung mit den Merkmalen des Anspruchs 9 gelöst. Demnach ist eine Winkelsensoreinheit zur Messung eines Drehwinkels der Drehlage einer Lenkwelle eines Kraftfahrzeuges aufweisend einen Multipol-Magnetring mit einer Anzahl an Polpaaren, der mit der Lenkwelle drehfest verbindbar ist, wenigstens zwei Magnetfeldsensoren, die dem Multipol-Magnetring zugeordnet sind und eine Auswerteeinheit, die dazu eingerichtet ist, anhand der Signale der wenigstens zwei Magnetfeldsensoren einen

Drehwinkel zu bestimmen, vorgesehen, wobei die wenigstens zwei Magnetfeldsensoren an der Außenseite des Multipol-Magnetrings, in Umfangsrichtung versetzt angeordnet sind derart, dass ein von dem Multipol-Magnetring ausgehendes Magnetfeld im Bereich beider Magnetfeldsensoren einen annähernd gleichen Absolutwert, aber entgegengesetzte Vorzeichen aufweist. Diese Anordnung ermöglicht, Streufeldstörungen durch differentielle Messungen der beiden Magnetfeldsensoren zu eliminieren und somit einen störfreien Drehwinkel zu bestimmen.

Die sensitiven Sensorflächen der beiden Sensoren liegen bevorzugt in einer Ebene, die sich tangential zur Außenfläche des Multipol-Magnetrings, in der Mitte zwischen den beiden Sensoren erstreckt. Der vektorielle magnetische Fluss des von dem Multipol-Magnetring erzeugten Magnetfelds schließt mit der Ebene der Sensorfläche vom Betrag her denselben Winkel ein, d. h. |α| = |β|. Ein externes magnetisches Störfeld ist bevorzugt homogen im Bereich der beiden Sensoren.

Vorzugsweise weisen die Magnetfeldsensoren in Umfangsrichtung einen Abstand auf, der kleiner als 45°, insbesondere kleiner als 20° ist.

In einer vorteilhaften Ausführungsform sind die Magnetfeldsensoren in Umfangsrichtung um einen Pol versetzt angeordnet. So wird sichergestellt, dass das Störfeld im Bereich beider Sensoren homogen ist und sich mittels einer differentiellen Messung rausrechnen lässt.

Vorzugsweise liegen die sensitiven Sensorflächen der Magnetfeldsensoren in einer Ebene und weisen einen Abstand in einem Bereich zwischen 40% und 90% des Durchmessers des Multipol-Magnetrings auf.

Der Multipol-Magnetring hat bevorzugt wenigstens vier Polpaare.

Die Auswerteeinheit ist vorzugsweise dazu eingerichtet, einen Drehwinkel unabhängig von einem externen magnetischen Störfeld durch Differenzbildung der Signale der beiden Magnetfeldsensoren zu bestimmen.

Zur absoluten Winkelbestimmung über eine Umdrehung ist erfindungsgemäß vorgesehen, einen Zweipol-Magnetring mit zugeordnetem Magnetfeldsensor der Anordnung hinzuzufügen.

Die Pole des Multipol-Magnetrings sind bevorzugt durch Permanentmagnete gebildet und/oder die Magnetfeldsensoren sind Hallsensoren oder xMR-Sensoren.

In einem weiteren Beispiel, welches nicht zur Erfindung gehört, ist eine Winkelsensoreinheit zur Messung eines Drehwinkels der Drehlage einer Lenkwelle eines Kraftfahrzeuges aufweisend zwei Multipol-Magnetringe mit einer gleichen Anzahl an Polpaaren und einer gemeinsamen Symmetrieachse, die mit der Lenkwelle drehfest verbindbar sind, zwei Magnetfeldsensoren, wobei jeweils ein Magnetfeldsensor einem Multipol-Magnetring zugeordnet ist und eine Auswerteeinheit, die dazu eingerichtet ist, anhand der Signale der zwei Magnetfeldsensoren einen Drehwinkel zu bestimmen, vorgesehen, wobei die Multipol-Magnetringe zueinander um einen Pol versetzt in Umfangsrichtung angeordnet sind und die zwei Magnetfeldsensoren an der jeweiligen Außenseite des Multipol-Magnetrings an derselben Position in Umfangsrichtung und in einem geringen Abstand zueinander in Axialrichtung angeordnet sind. Der Abstand der beiden Magnetfeldsensoren und das im Bereich der Sensoren ausgebildete Magnetfeld sind somit derart ausgestaltet, dass sich über eine Differenzmessung ein störfreier Drehwinkel messen lässt. Die beiden Multipol-Magnetringe sind vorzugsweise identisch und liegen in Axialrichtung hintereinander, bevorzugt in Anlage.

In diesem Beispiel weisen die Multipol-Magnetringe jeweils eine axiale Polbreite auf und der Abstand zwischen den Magnetfeldsensoren ist kleiner als 110% der axialen Polbreite, und insbesondere größer als 90%.

In diesem Beispiel ist der Abstand zwischen den Magnetfeldsensoren zwischen 40% und 60% der gesamten Erstreckung der zwei Multipol-Magnetringe in Axialrichtung.

Weiterhin ist eine elektromechanische Hilfskraftlenkung für ein Kraftfahrzeug, umfassend eine Lenkwelle die drehbar um eine Lenkwellendrehachse gelagert ist und verschiedene Drehlagen einnehmen kann, einen Elektromotor zur Unterstützung einer Lenkbewegung und eine zuvor genannte Winkelsensoreinheit, vorgesehen.

Die zuvor genannte Winkelsensoreinheit kann auch in einem Steer-by-Wire-Lenksystem für Kraftfahrzeuge aufweisend einen auf die gelenkten Räder wirkenden, in Abhängigkeit eines Fahrerlenkwunsches elektronisch geregelten Lenksteller, einen Rückwirkungen der Straße auf ein Steuer übertragenden Feedback-Aktuator, eine Steuereinheit, die den Feedback-Aktuator und den Lenksteller ansteuert, eingesetzt werden.

Weiterhin ist ein Verfahren zur Bestimmung eines Drehwinkels der Drehlage einer drehbar gelagerten Lenkwelle eines Kraftfahrzeuges mit einer Winkelsensoreinheit aufweisend einen Multipol-Magnetring mit einer Anzahl an Polpaaren, der mit der Lenkwelle drehfest verbindbar ist, einen ersten und einen zweiten Magnetfeldsensor, die dem Multipol-Magnetring zugeordnet sind und eine Auswerteeinheit, die dazu eingerichtet ist, anhand der Signale der zwei Magnetfeldsensoren einen Drehwinkel zu bestimmen, vorgesehen, wobei die zwei Magnetfeldsensoren an der Außenseite des Multipol-Magnetrings, in Umfangsrichtung versetzt angeordnet sind und das Verfahren folgende Schritte umfasst:
- Einbringen der Winkelsensoreinheit in ein magnetisches Störfeld,
- Anordnen der zwei Magnetfeldsensoren an der Außenseite des Multipol-Magnetrings, derart, dass das magnetische Störfeld im Bereich beider Magnetfeldsensoren annähernd homogen ist und dass ein von dem Multipol-Magnetring ausgehendes Magnetfeld im Bereich beider Magnetfeldsensoren einen annähernd gleichen Absolutwert, aber entgegengesetzte Vorzeichen aufweist,
- Messen eines Magnetfelds mittels des ersten Magnetfeldsensors,
- Messen eines Magnetfelds mittels des zweiten Magnetfeldsensors,
- Zerlegen der beiden gemessenen Signale in radiale und tangentiale Komponenten,
- Bilden einer Differenz zwischen den beiden radialen Komponenten und den beiden tangentialen Komponenten, und
- Ermitteln des Drehwinkels unabhängig von einem externen magnetischen Störfeld mittels einer arctan-Funktion, und
· Ermitteln des absoluten Drehwinkels unter Verwendung eines zusätzlichen Zweipol-Magnetrings mit einem zugeordneten Magnetfeldsensor.

Eine solche Arkustangens-Bestimmung kann beispielsweise auf der Basis von Nachschlagtabellen, einem CORDIC-Algorithmus (CORDIC = Coordinate Rotation Digital Computer = Digitalcomputer zur Koordinatenrotation) oder einer ähnlichen Implementation implementiert werden. Es ergeben sich durch das Verfahren die zuvor genannten Vorteile.

Vorzugsweise wird bei der Differenzbildung eine Gewichtung vorgenommen. In einem bevorzugten Ausführungsbeispiel sind die Magnetfeldsensoren in Umfangsrichtung um einen Pol versetzt angeordnet. Weitere bevorzugte Ausgestaltungen können der zuvor beschriebenen Vorrichtung entnommen werden.

Es kann in einem Beispiel, welches nicht zur Erfindung gehört, auch vorgesehen sein, dass das Verfahren zur Bestimmung eines Drehwinkels der Drehlage einer drehbar gelagerten Lenkwelle eines Kraftfahrzeuges von einer Winkelsensoreinheit aufweisend zwei Multipol-Magnetringe mit einer gleichen Anzahl an Polpaaren und einer gemeinsamen Symmetrieachse, die mit der Lenkwelle drehfest verbindbar sind, einen ersten und einen zweiten Magnetfeldsensor, wobei jeweils ein Magnetfeldsensor einem Multipol-Magnetring zugeordnet ist und eine Auswerteeinheit, die dazu eingerichtet ist, anhand der Signale der zwei Magnetfeldsensoren einen Drehwinkel zu bestimmen, durchgeführt wird, wobei die Multipol-Magnetringe zueinander um einen Pol versetzt in Umfangsrichtung angeordnet sind und die zwei Magnetfeldsensoren an der jeweiligen Außenseite des Multipol-Magnetrings an derselben Position in Umfangsrichtung und in einem geringen Abstand zueinander in Axialrichtung angeordnet sind und das Verfahren folgende Schritte umfasst:
- Messen eines Magnetfelds mittels des ersten Magnetfeldsensors,
- Messen eines Magnetfelds mittels des zweiten Magnetfeldsensors,
- Zerlegen der beiden gemessenen Signale in radiale und tangentiale Komponenten,
- Bilden einer Differenz zwischen den beiden radialen Komponenten und den beiden tangentialen Komponenten, und
- Ermitteln des Drehwinkels unabhängig von einem externen magnetischen Störfeld mittels einer arctan-Funktion.

Dabei weisen die Multipol-Magnetringe jeweils eine axiale Polbreite auf und der axiale Abstand zwischen den Magnetfeldsensoren kleiner als 110%, und insbesondere größer als 90%, der axialen Polbreite ist.

Dabei ist der axiale Abstand zwischen den Magnetfeldsensoren zwischen 40% und 60% der gesamten Erstreckung der zwei Multipol-Magnetringe in Axialrichtung. Weitere bevorzugte Ausgestaltungen können der zuvor beschriebenen Vorrichtung entnommen werden.

Bevorzugte Ausführungsformen der Erfindung werden nachfolgend anhand der Zeichnungen näher erläutert. Gleiche bzw. funktionsgleiche Bauteile sind dabei figurübergreifend mit denselben Bezugszeichen versehen. Es zeigen:
- Fig. 1:: eine schematische Darstellung eines erfindungsgemäßen Lenkwinkelsensors mit zwei Sensoren und einem Multipol-Magnetring,
- Fig. 2:: ein Blockdiagramm zur Berechnung des Drehwinkels mittels des Lenkwinkelsensors der Figur 1,
- Fig. 3: (gehört nicht zur Erfindung): eine schematische Darstellung eines erfindungsgemäßen Lenkwinkelsensors mit zwei Sensoren und zwei Multipol-Magnetringen, sowie
- Fig. 4: (gehört nicht zur Erfindung): einen elektrischen Schaltplan des Lenkwinkelsensors der Figur 3.

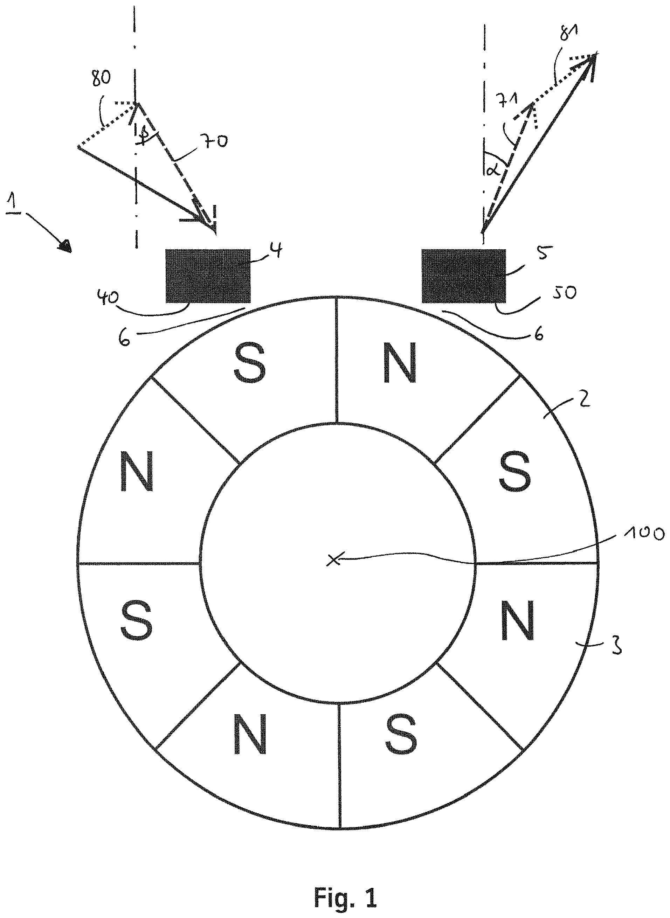

In der Figur 1 ist schematisch eine Lenkwinkelsensoreinheit 1 dargestellt. Ein Multipol-Magnetring 2 umgibt eine nicht dargestellte Welle konzentrisch und ist mit dieser Welle drehfest verbunden. Der Multipol-Magnetring 2 weist entlang seines Umfangs eine Mehrzahl von Permanentmagneten auf. Die Anordnung der Magneten 3 ist derart gewählt, dass sich entlang des Außenrandes des Multipol-Magnetrings 2 abwechselnd ein Nord- und ein Südpol befindet. Somit führt eine Drehung des Multipol-Magnetrings 2 bzw. der Welle zu einem zeitlich wechselnden Magnetfeld, welches von zwei Sensoren 4,5 erfasst wird. Die beiden Sensoren 4,5 sind bevorzugt HallSensoren. Sie sind raumfest angeordnet. Die Sensoren 4,5 liegen auf der Außenseite des Multipol-Magnetrings 2 und sind zu diesem radial in Bezug auf eine Längsachse 100, über einen kleinen Luftspalt 6 zur Messung des von dem Multipol-Magnetring 2 ausgehenden Magnetfelds beabstandet angeordnet. Die beiden Sensoren 4,5 sind in Umfangsrichtung um die Längsachse 100 mit einem Abstand von einem Pol angeordnet. In anderen Worten ausgedrückt, ist ein erster Sensor 4 einem Südpol und ein zweiter Sensor 5 einem unmittelbar an den Südpol grenzenden Nordpol zugewandt. Die Sensoren 4,5 weisen daher bei X Polpaaren einen Abstand in Umfangsrichtung von 360°/(2*X) auf.

Zur Bestimmung des Drehwinkels werden die Signale der beiden Sensoren 4,5 in einer Auswerteeinheit ausgewertet. Um den Drehwinkel in einem weiten Winkelbereich messen zu können, ist die Auswerteeinheit mit einem Inkrementalzähler ausgestattet, so dass bei einer größeren Drehung des Multipol-Magnetrades 2 die Perioden einer erzeugten periodischen Schwankung der Magnetfeldstärke gezählt werden können. Somit kann nach einer anfänglichen Initialisierung des Drehwinkels jeder beliebige Drehwinkel innerhalb eines Winkelbereichs von 0° bis 360° mit hoher Genauigkeit von jedem der beiden Sensoren 4,5 detektiert werden.

Die Sensoren liegen in Umfangsrichtung so nahe beieinander, dass angenommen werden kann, dass ein externes magnetisches Störfeld im Bereich beider Sensoren homogen ist. Die sensitiven Sensorflächen der beiden Sensoren 40,50 liegen in einer Ebene, die sich tangential zur Außenfläche des Multipol-Magnetrings 2, in der Mitte zwischen den beiden Sensoren 4,5 erstreckt. Der vektorielle magnetische Fluss des von dem Multipol-Magnetring 2 erzeugten Magnetfelds schließt mit der Ebene der Sensorfläche 40,50 vom Betrag her denselben Winkel ein, d. h. |α| = |β|. In der Figur 1 ist das von dem Multipol-Magnetring in der Ebene der beiden Sensorflächen 40,50 erzeugte Magnetfeld als gestrichelter Vektor 70,71 dargestellt, wobei α der Winkel ist, den der Vektor 71 mit dem Lot auf der Sensorfläche 50 einschließt und β der Winkel ist, den der Vektor 70 mit dem Lot auf der Sensorfläche 40 einschließt. Ein externes Störfeld 80,81 (gepunktete Vektoren) und das von den Sensoren gemessene resultierende Magnetfeld 90,91 (durchgehender Strich) sind ebenfalls als Vektor dargestellt. Wie bereits erläutert, kann angenommen werden, dass das Störfeld 80,81 für beide Sensoren gleich ist.

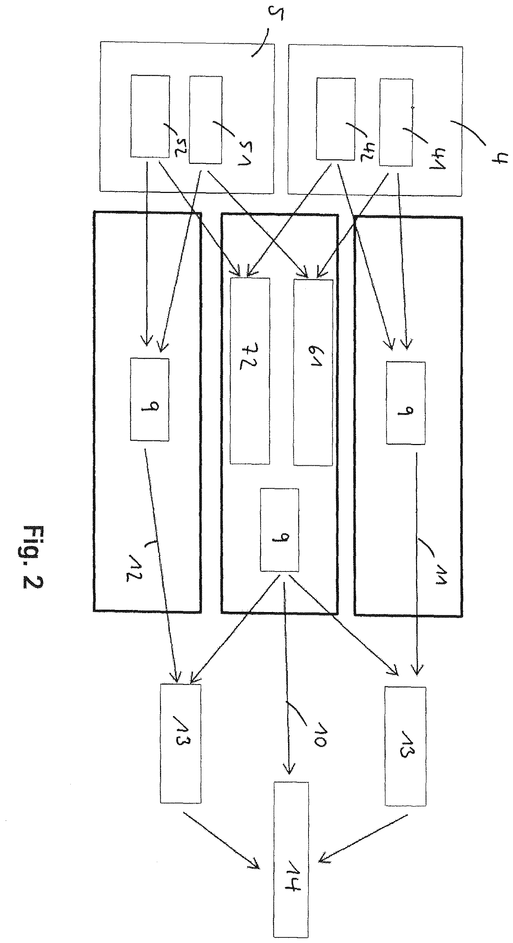

Die Signale der beiden Sensoren 4,5 werden in tangentiale Komponenten 41,51 und radiale Komponenten 41,51 zerlegt, wie in dem Blockdiagramm zur Bestimmung des Drehwinkels der Figur 2 dargestellt ist. Es werden jeweils die radialen und tangentialen Signalkomponenten der beiden Sensoren 41,51,41,51 voneinander gewichtet abgezogen 61,72, um ein störfreies Signal zu erhalten. Dabei kann es vorgesehen sein, eine Verzögerung und einen Offset in den Signalen unabhängig voneinander einzustellen. Wird eine xMR-Technologie als Sensor eingesetzt, ist es möglich, vollständige Vektoren mit abgeschätzter Stärke zu erstellen, sodass ein Gewicht anhand der Nennflussdichte bestimmt werden kann.

Anschließend wird mittels der störfreien radialen und tangentialen Komponente 61,72 unter Verwenden einer arctan-Funktion 9 der korrigierte Drehwinkel 10 bestimmt. Zudem wird der Drehwinkel 11,12 jeweils aus den Signalen der beiden einzelnen Sensoren zur Gegenprobe 13 bestimmt. Der störfreie Drehwinkel 10 ist dabei gegenüber den beiden mittels eines einzelnen Sensors ermittelten Drehwinkeln 11,12 um einen halben Polabstand verschoben. Wenn der störfreie, korrigierte Drehwinkel 13 bei der Gegenprobe plausibel erscheint, wird er an eine Motorsteuerung 14 eines Elektromotors weitergegeben. Falls dies nicht der Fall ist, können auch die herkömmlicherweise ermittelten Drehwinkel 11,12 für die Motorsteuerung verwendet werden. Bei elektromechanischen Hilfskraftlenkungen wird in Abhängigkeit des Drehwinkels eine mittels des Elektromotors bereitgestellte Hilfskraftunterstützung bestimmt. Es kann aber auch vorgesehen sein, die Lenkwinkelsensoreinheit in einer Steer-by-Wire Lenkung einzusetzen.

Zur absoluten Lenkwinkelbestimmung ist zusätzlich zu dem Multipol-Magnetring ein Zweipol-Magnetring vorgesehen. Das Magnetfeld des Multipol-Magnetrings wird, wie beschrieben, von zwei Sensoren abgetastet, so dass ein störfreier Drehwinkel bestimmt werden kann. Damit über den gesamten Messbereich von 0° bis 360° der Winkel absolut bestimmt werden kann, wird das Magnetfeld des zusätzlichen Zweipol-Magnetrings von einem dritten Sensor erfasst. Der dritte Sensor ist in unmittelbarer Nähe zu der Außenfläche des Zweipol-Magnetrings angeordnet. Der Zweipol-Magnetring ist von dem Multipol-Magnetring in Richtung der Längsachse beabstandet angeordnet, damit die Magnetfelder keinen störenden Einfluss aufeinander haben.

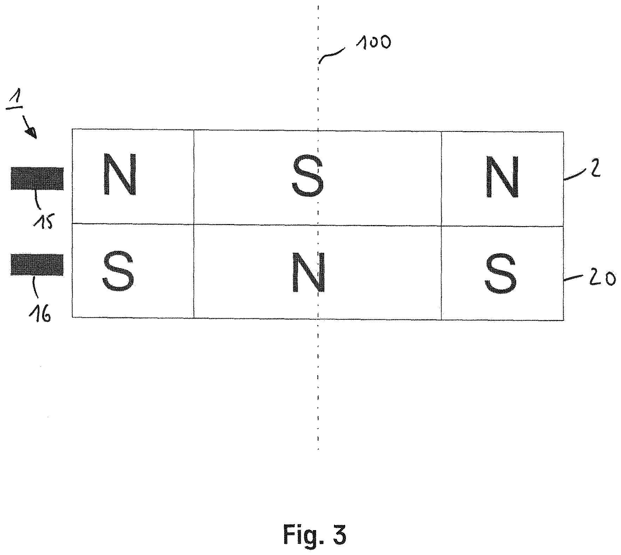

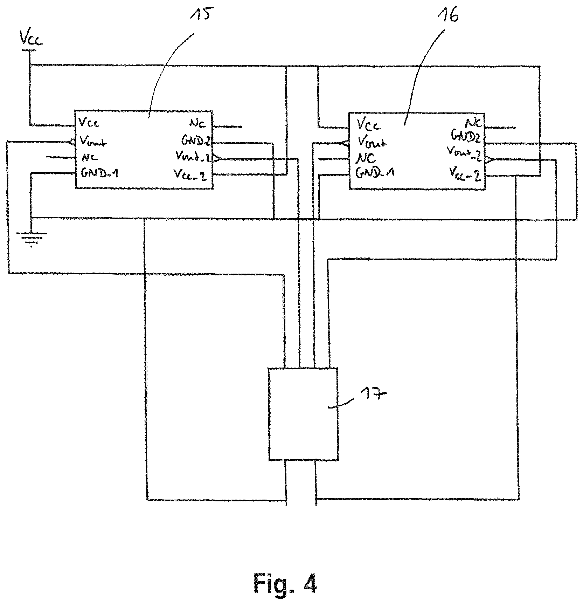

Figur 3 zeigt ein weiteres, nicht zur Erfindung gehöriges Beispiel der Lenkwinkelsensoreinheit 1. Es sind zwei Multipol-Magnetringe 2,20 vorgesehen, die eine gleiche Anzahl an Polpaaren aufweisen, die gleichmäßig über den Umfang verteilt sind. Die Magnetringe 2,20 sind dabei um einen Pol versetzt zueinander in Umfangsrichtung ausgerichtet und ansonsten deckungsgleich zur Längsachse des Sensors 100. Jeder Magnetring 2,20 erzeugt ein eigenes Magnetfeld, das von einem jeweiligen Sensor 15,16, bevorzugt Hallsensoren, gemessen wird. Die beiden Sensoren 15,16 liegen dabei bevorzugt mit ihren Sensorflächen in einer Ebene parallel zur Längsachse der Sensoreinheit 100 und jeweils Mittig zum entsprechenden Multipol-Magnetring 2,20. Figur 4 zeigt einen elektrischen Schaltplan der entsprechenden Lenkwinkelsensoreinheit. Der Abstand zwischen den beiden Sensoren 15,16 ist so gering, dass das Störfeld im Bereich der beiden Sensoren 15,16 homogen ist. Da das von den beiden Multipol-Magnetringen erzeugte vektorielle Magnetfeld im Bereich der sensitiven Sensorfläche des jeweiligen Sensors 2,20 parallel, mit entgegengesetzter Richtung ist, kann durch Subtraktion der beiden Signale, eine Störkomponente eines externen Störfeldes bestimmt werden. Dafür werden die beiden Sensorsignale wieder jeweils in eine tangentiale und radiale Komponente aufgetrennt. Die Komponenten werden jeweils voneinander in einem einfachen Mikrokontroller 17 abgezogen und der störfreie, korrigierte Drehwinkel wird unter Verwendung einer arctan-Funktion berechnet.

## Patentansprüche

1. Winkelsensoreinheit (1) zur Messung eines Drehwinkels der Drehlage einer Lenkwelle eines Kraftfahrzeuges aufweisend einen Multipol-Magnetring (2) mit einer Anzahl an Polpaaren, der mit der Lenkwelle drehfest verbindbar ist, zwei Magnetfeldsensoren (4,5), die dem Multipol-Magnetring (2) zugeordnet sind und eine Auswerteeinheit, die dazu eingerichtet ist, anhand der Signale der wenigstens zwei Magnetfeldsensoren (4,5) einen Drehwinkel zu bestimmen, wobei die zwei Magnetfeldsensoren (4,5) an der Außenseite des Multipol-Magnetrings (2), in Umfangsrichtung versetzt angeordnet sind, derart, dass ein von dem Multipol-Magnetring (2) ausgehendes Magnetfeld im Bereich beider Magnetfeldsensoren (4,5) einen annähernd gleichen Absolutwert, aber entgegengesetzte Vorzeichen aufweist, **dadurch gekennzeichnet, dass** die Winkelsensoreinheit (1) zusätzlich einen Zweipol-Magnetring mit zugeordnetem Magnetfeldsensor zur absoluten Bestimmung des Drehwinkels aufweist, wobei der Zweipol-Magnetring von dem Multipol-Magnetring in Richtung der Längsachse beabstandet angeordnet ist.

2. Winkelsensoreinheit nach Anspruch 1, **dadurch gekennzeichnet, dass** die Magnetfeldsensoren (4,5) in Umfangsrichtung einen Abstand aufweisen, der kleiner als 45° ist.

3. Winkelsensoreinheit nach Anspruch 1 oder 2, **dadurch gekennzeichnet, dass** die Magnetfeldsensoren (4,5) in Umfangsrichtung einen Abstand aufweisen, der kleiner als 20° ist.

4. Winkelsensoreinheit nach einem der vorhergehenden Ansprüche,
**dadurch gekennzeichnet, dass** die Magnetfeldsensoren (4,5) in Umfangsrichtung um einen Pol versetzt angeordnet sind.

5. Winkelsensoreinheit nach einem der vorhergehenden Ansprüche,
**dadurch gekennzeichnet, dass** die sensitiven Sensorflächen (40,50) der Magnetfeldsensoren (4,5) in einer Ebene liegen und einen Abstand in einem Bereich zwischen 40% und 90% des Durchmessers des Multipol-Magnetrings (2) aufweisen.

6. Winkelsensoreinheit nach einem der vorhergehenden Ansprüche,
**dadurch gekennzeichnet, dass** die Auswerteeinheit dazu eingerichtet ist, einen Drehwinkel unabhängig von einem externen magnetischen Störfeld durch Differenzbildung der Signale der beiden Magnetfeldsensoren (4,5) zu bestimmen.

7. Elektromechanische Hilfskraftlenkung für ein Kraftfahrzeug, umfassend eine Lenkwelle die drehbar um eine Lenkwellendrehachse gelagert ist und verschiedene Drehlagen einnehmen kann, einen Elektromotor zur Unterstützung einer Lenkbewegung und eine Winkelsensoreinheit (1) gemäß einem der Ansprüche 1 bis 6.

8. Steer-by-Wire-Lenksystem für Kraftfahrzeuge aufweisend einen auf die gelenkten Räder wirkenden, in Abhängigkeit eines Fahrerlenkwunsches elektronisch geregelten Lenksteller, einen Rückwirkungen der Straße auf ein Steuer übertragenden Feedback-Aktuator, eine Steuereinheit, die den Feedback-Aktuator und den Lenksteller ansteuert, und eine Winkelsensoreinheit (1) gemäß einem der Ansprüche 1 bis 6.

9. Verfahren zur Bestimmung eines Drehwinkels der Drehlage einer drehbar gelagerten Lenkwelle eines Kraftfahrzeuges mit einer Winkelsensoreinheit aufweisend einen Multipol-Magnetring (2) mit einer Anzahl an Polpaaren, der mit der Lenkwelle drehfest verbindbar ist, einen ersten und einen zweiten Magnetfeldsensor (4,5), die dem Multipol-Magnetring (2) zugeordnet sind und eine Auswerteeinheit, die dazu eingerichtet ist, anhand der Signale der zwei Magnetfeldsensoren (4,5) einen Drehwinkel zu bestimmen, weiter aufweisend einen Zweipol-Magnetring mit zugeordnetem Magnetfeldsensor zur absoluten Bestimmung des Drehwinkels, wobei der Zweipol-Magnetring von dem Multipol-Magnetring in Richtung der Längsachse beabstandet angeordnet ist, und wobei die zwei Magnetfeldsensoren (4,5) an der Außenseite des Multipol-Magnetrings (2), in Umfangsrichtung versetzt angeordnet sind und das Verfahren folgende Schritte umfasst:
• Einbringen der Winkelsensoreinheit in ein magnetisches Störfeld,
• Anordnen der zwei Magnetfeldsensoren (4,5) an der Außenseite des Multipol-Magnetrings (2), derart, dass das magnetische Störfeld im Bereich beider Magnetfeldsensoren (4,5) annähernd homogen ist und dass ein von dem Multipol-Magnetring (2) ausgehendes Magnetfeld im Bereich beider Magnetfeldsensoren (4,5) einen annähernd gleichen Absolutwert, aber entgegengesetzte Vorzeichen aufweist,
• Messen eines Magnetfelds mittels des ersten Magnetfeldsensors (4),
• Messen eines Magnetfelds mittels des zweiten Magnetfeldsensors (5),
• Zerlegen der beiden gemessenen Signale in radiale und tangentiale Komponenten (41,42,51,52),
• Bilden einer Differenz zwischen den beiden radialen Komponenten (61) und den beiden tangentialen Komponenten (72), wobei bei der Differenzbildung insbesondere eine Gewichtung vorgenommen werden kann,
• Ermitteln des Drehwinkels unabhängig von einem externen magnetischen Störfeld mittels einer arctan-Funktion (9), und
• Ermitteln des absoluten Drehwinkels unter Verwendung des zusätzlichen Zweipol-Magnetrings mit dem zugeordneten Magnetfeldsensor.

10. Verfahren nach Anspruch 9, **dadurch gekennzeichnet, dass** die Magnetfeldsensoren (4,5) in Umfangsrichtung um einen Pol versetzt angeordnet sind.

## Claims

1. An angle sensor unit (1) for measuring a rotational angle of the rotational position of a steering shaft of a motor vehicle having a multipole magnetic ring (2) which has a number of pole pairs and can be connected in a torque-proof manner to the steering shaft, two magnetic field sensors (4, 5) which are assigned to the multipole magnetic ring (2) and an evaluation unit which is configured to determine a rotational angle on the basis of the signals of the at least two magnetic field sensors (4, 5), wherein the two magnetic field sensors (4, 5) are arranged offset in the circumferential direction on the outside of the multipole magnetic ring (2), in such a way that a magnetic field which originates from the multipole magnetic ring (2), in the region of the two magnetic field sensors (4, 5), has an approximate equal absolute value but opposite signs, **characterized in that** the angle sensor unit additionally has a two-pole magnetic ring with an assigned magnetic field sensor for the absolute determination of the rotational angle, wherein the two-pole magnetic ring is arranged spaced apart from the multipole magnetic ring in the direction of the longitudinal axis.

2. The angle sensor unit as claimed in claim 1, **characterized in that** the magnetic field sensors (4, 5) are spaced apart by a distance of less than 45° in the circumferential direction.

3. The angle sensor unit as claimed in claim 1 or 2, **characterized in that** the magnetic field sensors (4, 5) are spaced apart by a distance of less than 20° in the circumferential direction.

4. The angle sensor unit as claimed in one of the preceding claims, **characterized in that** the magnetic field sensors (4, 5) are arranged offset by one pole in the circumferential direction.

5. The angle sensor unit as claimed in one of the preceding claims, **characterized in that** the sensitive sensor faces (40, 50) of the magnetic field sensors (4, 5) are in a plane and are spaced apart by a distance in a range between 40% and 90% of the diameter of the multipole magnetic ring (2).

6. The angle sensor unit as claimed in one of the preceding claims, **characterized in that** the evaluation unit is configured to determine a rotational angle independently of an external magnetic interference field, by forming differences between the signals of the two magnetic field sensors (4, 5).

7. An electromechanical power steering system for a motor vehicle, comprising a steering shaft which is pivoted about a steering shaft rotational axis and can take in different rotational positions, an electric motor for assisting a steering movement and angle sensor unit (1) as claimed in one of claims 1 to 6.

8. A steer-by-wire steering system for motor vehicles having a steering actuator which acts on the steered wheels and is electronically regulated as a function of a driver's steering wheel request, a feedback actuator which transmits reactions of the road to a steering wheel, a control unit which controls the feedback actuator and the steering actuator, and an angle sensor unit (1) as claimed in one of claims 1 to 6.

9. A method for determining a rotational angle of the rotational position of a rotatably mounted steering shaft of a motor vehicle with an angle sensor unit having a multipole magnetic ring (2) which has a number of pole pairs and can be connected in a torque-proof manner to the steering shaft, a first and a second magnetic field sensor (4, 5) which are assigned to the multipole magnetic ring (2), and an evaluation unit which is configured to determine a rotational angle on the basis of the signals of the two magnetic field sensors (4, 5), further having a two-pole magnetic ring with an assigned magnetic field sensor for the absolute determination of the rotational angle, wherein the two-pole magnetic ring is arranged spaced apart from the multipole magnetic ring in the direction of the longitudinal axis, and wherein the two magnetic field sensors (4, 5) are arranged offset in the circumferential direction on the outside of the multipole magnetic ring (2), and the method comprises the following steps:
• introducing the angle sensor unit into a magnetic interference field,
• arranging the two magnetic field sensors (4, 5) on the outer side of the multipole magnetic ring (2) in such a way that the magnetic interference field is approximately homogeneous in the region of the two magnetic field sensors (4, 5), and in that a magnetic field which originates from the multipole magnetic ring (2) has, in the region of the two magnetic field sensors (4, 5), an approximately equal absolute value, but opposite signs,
• measuring a magnetic field by means of the first magnetic field sensor (4),
• measuring a magnetic field by means of the second magnetic field sensor (5),
• decomposing the two measured signals into radial and tangential components (41,42,51,52),
• forming a difference between the two radial components (61) and the two tangential components (72), wherein in particular weighting can be performed during the formation of differences,
• determining the rotational angle independently of an external magnetic interference field by means of an arctan function (9), and
• performing the absolute determination of the rotational angle by using the two-pole magnetic ring with the assigned magnetic field sensor.

10. The method as claimed in claim 9, **characterized in that** the magnetic field sensors (4, 5) are arranged offset by one pole in the circumferential direction.

## Revendications

1. Une unité de capteur d'angle (1) pour mesurer un angle de rotation de la position de rotation d'un arbre de direction d'un véhicule à moteur comporte un anneau magnétique multipolaire (2) qui a un certain nombre de paires de pôles et peut être relié de manière étanche au couple à l'arbre de direction, deux capteurs de champ magnétique (4, 5) qui sont affectés à l'anneau magnétique multipolaire (2) et une unité d'évaluation qui est configurée pour déterminer un angle de rotation sur la base des signaux d'au moins deux capteurs de champ magnétique (4, 5), dans laquelle les deux capteurs de champ magnétique (4, 5) sont disposés de manière décalée dans la direction circonférentielle à l'extérieur de l'anneau magnétique multipolaire (2), de telle sorte qu'un champ magnétique provenant de l'anneau magnétique multipolaire (2), dans la zone des deux capteurs de champ magnétique (4, 5), a une valeur absolue approximativement égale mais des signes opposés, **caractérisé en ce que** l'unité de capteur d'angle possède en outre un anneau magnétique bipolaire avec un capteur de champ magnétique affecté pour la détermination absolue de l'angle de rotation, dans lequel l'anneau magnétique bipolaire est disposé à distance de l'anneau magnétique multipolaire dans la direction de l'axe longitudinal.

2. L'unité de capteur d'angle selon la revendication 1, **caractérisée par le fait que** les capteurs de champ magnétique (4, 5) sont espacés d'une distance moins de 45° dans la direction circonférentielle.

3. L'unité de capteur d'angle selon la revendication 1 ou 2, **caractérisée par le fait que** les capteurs de champ magnétique (4, 5) sont espacés d'une distance moins de 20° dans la direction circonférentielle.

4. L'unité de capteur d'angle selon l'une des revendications précédentes, **caractérisée par le fait que** les capteurs de champ magnétique (4, 5) sont disposés en décalage d'un pôle dans la direction circonférentielle.

5. L'unité de capteur d'angle selon l'une des revendications précédentes, **caractérisée par le fait que** les faces sensibles (40, 50) des capteurs de champ magnétique (4, 5) sont dans un plan et sont espacées d'une distance comprise entre 40% et 90% du diamètre de l'anneau magnétique multipolaire (2).

6. L'unité de détection d'angle selon l'une des revendications précédentes, **caractérisée en ce que** l'unité d'évaluation est configurée pour déterminer un angle de rotation indépendamment d'un champ magnétique perturbateur externe, en formant des différences entre les signaux des deux capteurs de champ magnétique (4, 5).

7. Système de direction assistée électromécanique pour un véhicule automobile, comprenant un arbre de direction pivotant autour d'un axe de rotation de l'arbre de direction et pouvant prendre différentes positions de rotation, un moteur électrique pour assister un mouvement de direction et une unité de capteur d'angle (1) telle que revendiquée dans l'une des revendications 1 à 6.

8. Système de direction à commande électrique pour véhicules automobiles comportant un actionneur de direction qui agit sur les roues directrices et est régulé électroniquement en fonction de la demande du conducteur concernant le volant, un actionneur de rétroaction qui transmet les réactions de la route à un volant, une unité de commande qui contrôle l'actionneur de rétroaction et l'actionneur de direction, et une unité de capteur d'angle (1) comme indiqué dans l'une des revendications 1 à 6.

9. Procédé de détermination d'un angle de rotation de la position de rotation d'un arbre de direction monté rotatif d'un véhicule à moteur avec une unité de capteur d'angle comportant un anneau magnétique multipolaire (2) ayant un certain nombre de paires de pôles et pouvant être relié de manière étanche au couple à l'arbre de direction, un premier et un second capteur de champ magnétique (4, 5) affectés à l'anneau magnétique multipolaire (2), et une unité d'évaluation configurée pour déterminer un angle de rotation sur la base des signaux des deux capteurs de champ magnétique (4, 5), comportant en outre un anneau magnétique bipolaire avec un capteur de champ magnétique affecté pour la détermination absolue de l'angle de rotation, dans lequel l'anneau magnétique bipolaire est disposé à l'écart de l'anneau magnétique multipolaire dans la direction de l'axe longitudinal, et dans lequel les deux capteurs de champ magnétique (4, 5) sont disposés de manière décalée dans la direction circonférentielle à l'extérieur de l'anneau magnétique multipolaire (2), et le procédé comprend les étapes suivantes:
• en introduisant l'unité de détection d'angle dans un champ d'interférence magnétique,
• disposer les deux capteurs de champ magnétique (4, 5) sur le côté extérieur de l'anneau magnétique multipolaire (2) de telle sorte que le champ d'interférence magnétique soit approximativement homogène dans la région des deux capteurs de champ magnétique (4, 5) et qu'un champ magnétique provenant de l'anneau magnétique multipolaire (2) ait, dans la région des deux capteurs de champ magnétique (4, 5), une valeur absolue approximativement égale, mais des signes opposés,
• mesurer un champ magnétique au moyen du premier capteur de champ magnétique (4),
• mesurer un champ magnétique au moyen du deuxième capteur de champ magnétique (5),
• décomposition des deux signaux mesurés en composantes radiale et tangentielle (41,42,51,52),
• former une différence entre les deux composantes radiales (61) et les deux composantes tangentielles (72), une pondération particulière pouvant être effectuée lors de la formation des différences,
• déterminer l'angle de rotation indépendamment d'un champ d'interférence magnétique externe au moyen d'une fonction arctan (9), et
• effectuer la détermination absolue de l'angle de rotation en utilisant l'anneau magnétique bipolaire avec le capteur de champ magnétique assigné.

10. Procédé selon la revendication 9, **caractérisé par le fait que** les capteurs de champ magnétique (4, 5) sont décalés d'un pôle dans la direction circonférentielle.
